# EUROPÄISCHE PATENTSCHRIFT

(11) **EP 0 547 371 B1**
(45) Veröffentlichungstag und Bekanntmachung des Hinweises auf die Patenterteilung: **16.04.1997**
(21) Anmeldenummer: 92119256.3
(22) Anmeldetag: 11.11.1992
(51) Int. Cl.: G03F 7/00, C25D 1/10

(54) **Verfahren zum Herstellen gestufter Formeinsätze**
Process for producing stepped moulds
Procédé pour la fabrication de garnitures de moulage étagées

(30) Priorität: 19.12.1991 DE 4142001
(43) Veröffentlichungstag der Anmeldung: 23.06.1993
(73) Patentinhaber: microParts Gesellschaft für Mikrostrukturtechnik mbH, 44227 Dortmund (DE)
(72) Erfinder: Nöker, Friedolin Franz, Dipl.-Ing., W-5700 Karlsruhe 1 (DE)

(56) Entgegenhaltungen:
- EP-A- 0 232 973
- EP-A- 0 253 066
- EP-A- 0 374 441
- WO-A-91/07700
- I.E.E.E. CIRCUITS AND DEVICES MAGAZINE, Bd. 4, Nr. 5, September 1988, New York US, Seiten 11-17, XP45695; L.F. HALLE : 'Trends in Lithography'

## Beschreibung

Die Erfindung betrifft ein Verfahren zum Herstellen gestufter Formeinsätze, mit denen gestufte Mikrostrukturkörper hergestellt werden.

Die Erfindung bezweckt, gestufte Mikrostrukturkörper auf wirtschaftliche Weise herzustellen.

Nach dem LIGA-(Röntgentiefenlithographie-Mikrogalvanoformungsverfahren)-Verfahren hergestellte Mikrostrukturkörper haben Mikrostrukturen mit lateralen Abmessungen im Mikrometer-Bereich bei einer Höhe, die mehrere hundert Mikrometer betragen kann. Im allgemeinen sind die Mikrostrukturkörper planar, d. h. die lateralen Abmessungen der Mikrostrukturen sind über die ganze Strukturhöhe praktisch konstant.

Nach EP-184 608 lassen sich Körper mit säulenförmiger Mikrostruktur herstellen, die in zwei Bereichen unterschiedliche Höhen haben. Dazu wird eine Schicht eines durch Röntgenstrahlung in seinen Eigenschaften veränderbaren Kunststoffs (Resist-Material) zunächst mit Röntgenstrahlung durch eine strukturierte Maske hindurch partiell bestrahlt, wobei die Resist-Schicht in ihrer gesamten Dicke von der Röntgenstrahlung durchdrungen wird. Anschließend wird die Resist-Schicht erneut mit Röntgenstrahlung durch eine zweite strukturierte Maske hindurch partiell bestrahlt, wobei die Eindringtiefe der Strahlung geringer ist als die Dicke der Resist-Schicht und die bestrahlten Bereiche größer sind als bei der ersten Bestrahlung. Dieses Verfahren ist grundsätzlich geeignet, Mikrostrukturkörper mit mehr als zwei unterschiedlichen Strukturhöhen herzustellen. Für jede Strukturhöhe ist ein eigener Bestrahlungsschritt erforderlich. Für jeden Bestrahlungsschritt wird eine gesonderte Maske verwendet, die mit hoher Präzision relativ zu den bereits bestrahlten Bereichen der Resist-Schicht zu positionieren ist. Dadurch wird der Aufwand beträchtlich erhöht und die Ausbeute spürbar vermindert.

In EP-253 066 ist ein Verfahren zur Herstellung von Mikrostrukturkörpern mit Bereichen mit unterschiedlicher Strukturhöhe angegeben. Eine Resist-Schicht wird durch eine einzige Maske hindurch, deren Struktur der Struktur des Mikrostrukturkörpers entspricht (Absorberstruktur) einmalig bestrahlt (Röntgentiefenlithographie). Die Maske besteht aus einer strukturierten Schicht, die die Röntgenstrahlung fast vollständig absorbiert (Totalabsorberschicht), und mindestens einer weiteren strukturierten Schicht, die die Röntgenstrahlung nur teilweise absorbiert (Partialabsorberschicht). Das Resist-Material ist ein Kunststoff mit scharfer unterer Grenzdosis, z. B. Polymethyl-methacrylat. Für die Partialabsorberschichten werden Stoffe mit unterschiedlichem Absorptionsvermögen innerhalb des Wellenlängenbereiches der verwendeten Röntgenstrahlung verwendet. Die Art der Partialabsorber-Materialien, deren jeweilige Schichtdicke, das Spektrum der verwendeten Röntgenstrahlung und die Strahlungsdosis sind auf die gewünschten unterschiedlichen Strukturhöhen des Mikrostrukturkörpers abzustimmen. Dieses Verfahren erfordert umfangreiche Berechnungen.

Damit stellt sich die Aufgabe, zunächst gestufte Formeinsätze auf einfache Weise herzustellen, mit denen anschließend gestufte Mikrostrukturkörper abgeformt werden können.

Diese Aufgabe wird erfindungsgemäß gelöst durch ein Verfahren mit den in Anspruch 1 angegebenen Merkmalen. Die Grundplatte besteht aus einem elektrisch leitfähigen Material, bevorzugt aus einem Metall wie z. B. Kupfer, Stahl, Aluminium, Titan. Auch elektrisch leitfähige Kunststoffe sind geeignet; diese sind gegebenenfalls mit Ruß oder mit leitfähigen Fasern gefüllt. Auf die Grundplatte werden eine oder mehrere elektrisch nicht leitfähige Schichten aufgebracht. Diese bestehen aus einem oder gegebenenfalls verschiedenen Kunststoffen, die eine fest haftende Verbindung mit der Grundplatte oder der darunter liegenden Schicht ergeben. Als Kunststoffe sind z. B. Epoxidharze, Polyesterharze, Epoxy-Phenol-Harze und andere geeignet; für den Schichtaufbau werden bevorzugt solche Stoffe eingesetzt, deren Längenausdehnungskoeffizienten annähernd gleich groß sind; dann entstehen in den Schichten nur mäßig große mechanische Spannungen und praktisch keine Risse. Die elektrisch nicht leitfähigen Schichten werden durch Gießen, Kleben, Prägen, Aufpolymerisieren oder ähnliche Verfahren aufgebracht.

Die nicht leitfähigen Schichten haben eine Dicke, die für eine Schicht oder mehrere Schichten zusammengenommen der Höhe der zugehörigen Stufe des später abgeformten Mikrostrukturkörpers entspricht. Die Schichtdicke wird begrenzt durch die Stabilität der erzeugten Mikrostrukturen und durch die mit dem LIGA-Verfahren erreichbaren Strukturhöhen; die Dicke kann je nach Lateralabmessung bis zu etwa 1 000 Mikrometer betragen.

Auf jede nicht leitfähige Schicht wird eine elektrisch leitfähige Schicht (Zwischenschicht) aufgebracht, beispielsweise durch Aufdampfen, Kleben oder Sputtern oder - bei leitfähigen Kunststoffen - durch Aufgießen. Diese Schichten bestehen aus Metall, wie Gold, Silber, Titan, Kupfer, Nickel, oder aus leitfähigem Kunststoff. Die Dicke dieser leitfähigen (Zwischen-)Schichten beträgt im allgemeinen nur wenige Mikrometer; sie ist meistens vernachlässigbar gering gegen die Dicke der nicht leitfähigen Schichten; andernfalls wird ihre Dicke bei der Dicke der darunterliegenden nicht leitfähigen Schicht berücksichtigt. Die leitfähigen Schichten bilden beim späteren galvanischen Abscheiden von Metall die Galvanik-Startschichten (Elektroden) und werden dazu elektrisch kontaktiert oder kontaktieren sich selbst während des Aufwachsens von Metall.

Die auf die Grundplatte aufgebrachten Schichten werden durch mechanische Präzisionsverfahren vorstrukturiert. Hierzu gehören Bohren, Fräsen, Laserbearbeitung, Diamantzerspanen und andere Präzisions-Abtragungsverfahren. Der Boden jedes abgetragenen Bereiches wird - bevorzugt vollständig - durch eine der elektrisch leitfähigen Schichten oder durch die leitfähige Grundplatte gebildet. Die abgetragenen Bereiche gehen gegebenenfalls durch mehrere nicht leitfähige und leitfähige Schichten hindurch.

Die Präzisionsbearbeitung hat eine Tiefengenauigkeit im Mikrometerbereich. Eine mehrere Mikrometer dicke leitfähige Zwischenschicht darf also oberflächlich etwas abgetragen werden. Die relativ dicke Grundplatte oder eine hinreichend dicke Zwischenschicht darf sogar relativ tief angebohrt oder angefräst werden. Das Erreichen einer leitfähigen Schicht kann automatisch und exakt überwacht werden, z. B. durch Schließen eines Stromkreises zwischen leitfähiger Schicht und leitfähigem Abtragungswerkzeug. Bei Abtragungsverfahren mit geringerer Tiefengenauigkeit muß die leitfähige Schicht entsprechend dicker ausgeführt werden.

Für das spätere galvanische Abscheiden von Metall ist es erfahrungsgemäß ausreichend, wenn am Boden jedes abgetragenen Bereiches wenigstens ein elektrisch leitfähiger und von außen kontaktierbarer "Punkt" vorhanden ist, an dem das galvanische Abscheiden beginnt; die Ränder und Ecken am Boden eines abgetragenen Bereiches müssen nicht völlig frei von nicht leitfähigem Material sein.

Nach der mechanischen Präzisionsbearbeitung werden die abgetragenen Bereiche mit einem Resist-Material ausgefüllt; die Platte wird mit demselben Resist-Material abgedeckt in einer Dicke, die der Gesamthöhe des später abgeformten Mikrostrukturkörpers entspricht. Die Oberfläche der Resist-Schicht wird gegebenenfalls durch mechanische Präzisionsbearbeitung bis zur gewünschten Höhe abgetragen.

Als Resist-Material wird entweder ein Positiv-Resist, z. B. Polymethyl-methacrylat (PMMA) (z. B. Plexit 60 der Fa. Röhm) oder ein Negativ-Resist (z. B. Ray-PN (AZ-PN) der Fa. Hoechst) verwendet.

Die Resist-Schicht wird in ihrer gesamten Dicke durch strukturierte Masken hindurch, bevorzugt durch eine einzige strukturierte Maske, z. B. mit Röntgenstrahlung, bestrahlt. Als Röntgenstrahlung wird bevorzugt die Synchrotron-Strahlung aus einem Elektronen-Synchrotron mit z. B. 2,3 GeV Elektronen-Energie verwendet.

Durch die Bestrahlung wird der Positiv-Resist in den bestrahlten Bereichen löslich und bleibt in den unbestrahlten Bereichen unlöslich, der Negativ-Resist bleibt in den unbestrahlten Bereichen löslich und wird in den bestrahlten Bereichen unlöslich. Die "Löslichkeit" des Resists bezieht sich stets auf die Einwirkung eines speziellen Lösemittels ("Entwicklers") bei den gewählten Lösebedingungen.

Die durch die mechanische Präzisionsbearbeitung entstandenen Flächen in den auf die Grundplatte aufgebrachten Schichten liegen - zumindest bei den Flächen (Seitenwänden), die parallel zur Bestrahlungsrichtung verlaufen - bei einem Positiv-Resist bevorzugt ganz in den unbestrahlten Bereichen, bei einem Negativ-Resist bevorzugt ganz in den bestrahlten Bereichen; sie werden durch die unlöslich gewordenen bzw. unlöslich gebliebenen Gebiete der Resist-Schicht abgedeckt. Eine gewisse Rauhigkeit dieser mechanisch erzeugten Flächen ist annehmbar oder wünschenswert. Die durch mechanische Präzisionsbearbeitung erzeugten Seitenwände können jedoch zum Teil auch außerhalb der unbestrahlten Bereiche eines Positiv-Resists bzw. außerhalb der bestrahlten Bereiche eines Negativ-Resists liegen.

Nach dem Bestrahlen werden die löslich gewordenen oder löslich gebliebenen Bereiche der Resist-Schicht mit einem Lösemittel ("Entwickler") gelöst und entfernt. Für PMMA ist z. B. der GG-Entwickler nach DE-OS 30 39 110 geeignet; für den Negativ-Resist AZ-PN ist wäßrige Ammoniumhydroxid-Lösung als Entwickler geeignet.

Anschließend wird in den Bereichen, aus denen die Resist-Schicht herausgelöst wurde, ein Metall galvanisch abgeschieden. Hierzu sind Nickel, Kupfer, Gold, Legierungen aus Nickel und Kobalt oder Nickel und Eisen und andere geeignet. Nachdem die Struktur vollständig mit Metall gefüllt ist, wird weiteres Metall in einer zusammenhängenden bis mehrere Millimeter dicken Schicht galvanisch abgeschieden, um den Formeinsatz zusammenzuhalten und ihn für das spätere Abformen von Mikrostrukturkörpern hinreichend stabil zu machen; die mit Metall ausgefüllte Struktur wird also mit weiterem Metall überwachsen. Bei der Dicke der Überwachsungsschicht ist ein Kompromiß zwischen mechanischer Stabilität des Formeinsatzes und Zeitbedarf für das galvanische Abscheiden von Metall einzugehen.

Beim galvanischen Abscheiden von Metall ist es im allgemeinen hinreichend, den elektrischen Kontakt nur an die leitfähige Grundplatte anzulegen. Die darüber liegenden leitfähigen Schichten kontaktieren sich von selbst, sobald die auf der Grundplatte gestartete Metallschicht die entsprechende Dicke erreicht hat. Wenn man die leitfähigen (Zwischen-)Schichten separat kontaktiert, kann man den Ort und den Zeitpunkt der galvanischen Abscheidung bestimmen. Dieses kann z. B. genutzt werden, wenn vor dem Abscheiden von Nickel für den Formeinsatz Opferschichten aus Gold, Kupfer oder anderen Metallen zusätzlich abgeschieden werden sollen. Solche Opferschichten dienen zum Vermeiden von Graten (Unterplattierung).

Bei Bedarf wird die Oberfläche der galvanisch abgeschiedenen zusammenhängenden Metallschicht mechanisch plan bearbeitet.

Die Grundplatte wird - bevorzugt mechanisch - durch zerspanende Bearbeitung wie Fräsen oder Sägen abgetragen. Gegebenenfalls kann die Grundplatte auch abgerissen werden. Am günstigsten ist ein Abtragungsverfahren, bei dem keine Bearbeitungskräfte auftreten, wie z. B. Funkenerosion oder Ätzen. Auch eine Kombination verschiedener Abtragungsverfahren ist geeignet.

Gegebenenfalls werden die in Höhe der Grundplatten-Oberfläche befindlichen nun offenliegenden Bereiche des galvanisch abgeschiedenen Metalls mechanisch überarbeitet.

Anschließend werden die in dem galvanisch abgeschiedenen Metallkörper verbliebenen Teile der nicht leitfähigen und der leitfähigen Schichten entfernt. Hierzu kann nach dem Abtragen der Grundplatte die freigelegte Schicht beispielsweise mit einem Klebstoff übergossen werden, der nach dem Aushärten abgezogen wird und dabei die anhängenden Teile der zu entfernenden Schichten aus der Metallstruktur mitnimmt. Andererseits können die stehengebliebenen Teile der Resist-Schicht herausgelöst werden, gegebenenfalls nach einer Flutbestrahlung, und anschließend wird die Platte mit Klebstoff übergossen, der nach dem Aushärten abgezogen wird und dabei die anhängenden Teile der zu entfernenden Schichten aus der Metallstruktur mitnimmt. Weiter kann man die zu entfernenden Schichten selektiv herauslösen, wozu man Lösemittel verwendet, die wesentlich aggressiver sind als die vorher verwendeten "Entwickler"; außerdem kann man in diesem Fall die Lösetemperatur erhöhen.

Unter einer unlöslichen oder schwer löslichen leitfähigen Schicht verborgene nicht leitfähige Schichten können gegebenenfalls durch Unterätzen der leitfähigen (Metall-)Schicht freigelegt werden.

Nachdem alle Stoffe aus der galvanisch abgeschiedenen Metallstruktur entfernt worden sind, liegt der fertige metallische Formeinsatz vor.

Mit Hilfe des gestuften Formeinsatzes werden nach bekannten Verfahren gestufte Mikrostrukturkörper aus Kunststoff abgeformt. Zum Abformen sind Kunststoffe wie Polymethyl-methacrylat, Poly-oxymethylen, Polycarbonat, Polyamid, wärmeformbeständige und/oder chemikalienresistente Kunststoffe wie z. B. Polyvinyliden-fluorid (PVDF) oder Polyetheretherketon (PEEK) sowie pulverförmige Sinterwerkstoffe geeignet, wobei letztere gegebenenfalls durch Zusatz eines Bindemittels plastisch verformbar gemacht werden. Die dadurch erzeugten zur Mikrostruktur des gestuften Formeinsatzes komplementären Mikrostrukturen aus Kunststoff oder Sinterwerkstoff lassen sich in bekannter Weise aus dem Formeinsatz entnehmen, womit man den gestuften Mikrostrukturkörper erhält. Der gestufte Formeinsatz kann zum wiederholten Abformen derartiger Mikrostrukturkörper verwendet werden.

Aus metallischen Formeinsätzen mit geeigneter Mikrostruktur, z. B. mit konisch verlaufenden Wänden oder bei kleinem Aspektverhältnis, kann man zur Struktur des Formeinsatzes komplementäre Mikrostrukturen aus Metall abformen. Dazu wird in einem Formeinsatz z. B. aus einem relativ unedlen Metall (wie Kupfer oder Nickel) ein relativ edles Metall (wie Gold oder Platin) galvanisch abgeschieden.

Man kann entweder das relativ edle Metall nur bis zur Höhe der ehemals vorhandenen Oberfläche der Grundplatte abscheiden, oder man kann darüber hinaus weiteres relativ edles Metall in einer hinreichend dicken Schicht abscheiden und die Mikrostruktur überwachsen lassen. In beiden Fällen wird der ursprüngliche metallische Formeinsatz z. B. aus Nickel chemisch oder elektrochemisch herausgelöst und dabei geopfert. Für dieses Verfahren kann der ursprüngliche Formeinsatz also nur einmal verwendet werden.

Im ersten Fall erhält man einen gestuften Mikrostrukturkörper aus dem relativ edlen Metall (z. B. aus Gold). Im zweiten Fall erhält man einen gestuften Formeinsatz, dessen Mikrostruktur zur Mikrostruktur des ursprünglichen Formeinsatzes komplementär ist; dieser kann nun zum wiederholten Abformen gestufter Mikrostrukturkörper aus Kunststoff oder Sinterwerkstoff verwendet werden.

Das erfindungsgemäße Verfahren, die damit hergestellten gestuften Formeinsätze und die abgeformten gestuften Mikrostrukturkörper haben folgende Vorteile:
- Der gestufte Formeinsatz ist überaus maßhaltig, weil er während aller Verfahrensschritte auf einer festen Grundplatte aufgebaut wird.
- Das Verfahren zum Herstellen des gestuften Formeinsatzes ist wenig anfällig gegen Fehler, und der Ausschußanteil bei den fertigen Formeinsätzen ist gering.
- Zum Herstellen des Formeinsatzes ist bevorzugt nur eine einzige Bestrahlungsmaske erforderlich, wodurch der Aufwand in Grenzen gehalten wird.
- Zum Herstellen des Formeinsatzes ist bevorzugt nur eine einzige Bestrahlung erforderlich. Die Resist-Schicht wird bevorzugt in einem einzigen Schritt strukturiert; ein Versatz zwischen mehreren Strukturierungsschritten kann nicht auftreten.
- Die bei der späteren Abformung vorhandenen Oberflächen der strukturierten Resist-Schicht werden ganz oder überwiegend lithographisch erzeugt und haben bekanntermaßen eine äußerst geringe Rauhtiefe. Die durch mechanische Präzisionsbearbeitung erzeugten Wände dagegen dürfen oder sollen relativ rauh sein.
- Der gestufte Formeinsatz wird ohne Unterbrechung durch galvanisches Abscheiden von Metall hergestellt.
- Die elektrisch leitfähigen (Zwischen-)Schichten sind plan, auch bei unterschiedlichen Strukturhöhen des mehrstufigen Formeinsatzes.
- Für die Strukturierung des Schichtenstapels auf der Grundplatte werden elektronisch gesteuerte, programmierbare, vollautomatisch arbeitende Maschinen mit hoher Reproduzierbarkeit und hoher Maßhaltigkeit eingesetzt.

Wird auf die Grundplatte nur eine nicht leitfähige Schicht aufgebracht, die mit einer relativ dünnen leitfähigen Schicht abgedeckt ist, kann man gestufte strukturierte Formeinsätze erhalten, mit denen einstückige zweistufige Mikrostrukturkörper abgeformt werden können. Werden auf die Grundplatte nacheinander mehrere nicht leitfähige Schichten aufgebracht, zwischen denen jeweils eine relativ dünne leitfähige Schicht liegt, kann man gestufte strukturierte Formeinsätze herstellen, mit denen einstückige mehrstufige Mikrostrukturkörper abgeformt werden können. Für jede Strukturhöhe des gestuften Mikrostrukturkörpers wird eine elektrisch leitfähige (Zwischen-)Schicht vorgesehen.

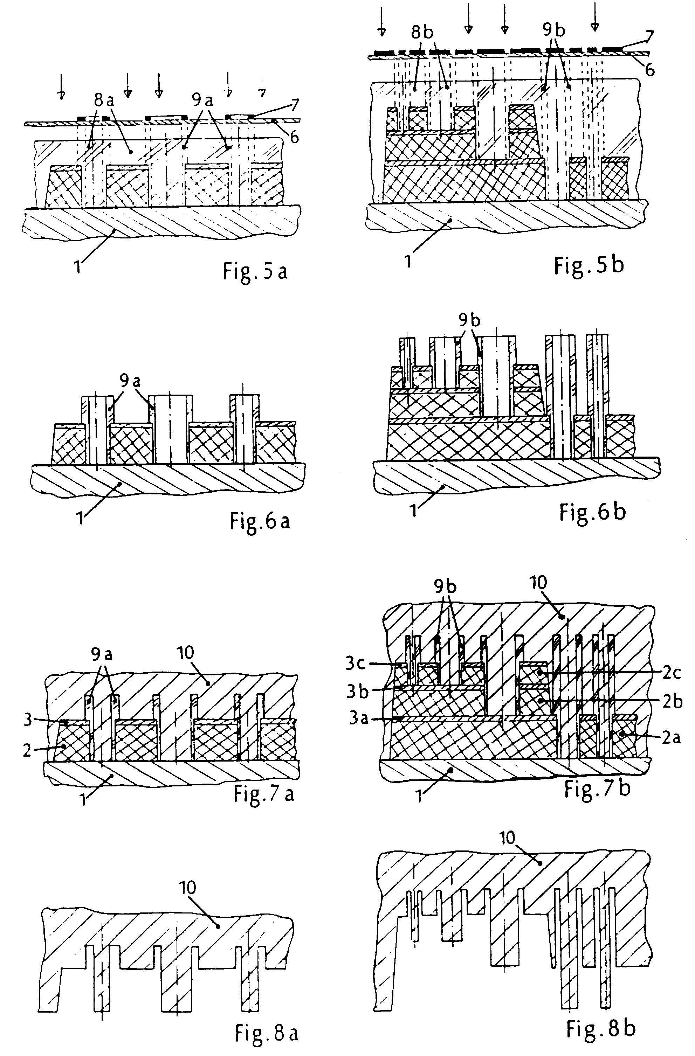

Die Erfindung wird an Hand der Figuren näher erläutert. Die Figuren 1a bis 8a zeigen die Herstellung eines zweistufigen Formeinsatzes unter Verwendung eines Positiv-Resists. Auf die Grundplatte (1) mit planer oder plan bearbeiteter Oberfläche werden eine elektrisch nicht leitfähige Schicht (2) und eine elektrisch leitfähige Schicht (3) aufgebracht. Durch mechanische Präzisionsbearbeitung werden beide Schichten in den Bereichen (4) bis zur Oberfläche der Grundplatte abgetragen. Die abgetragenen Bereiche werden mit einem Positiv-Resist (5a) ausgefüllt, und weiteres Resist-Material wird aufgetragen. Die Oberfläche der zusammenhängenden Resist-Schicht kann bei Bedarf mechanisch plan bearbeitet werden. Die Resist-Schicht wird durch eine Maske hindurch bestrahlt, wobei die Strahlung die Resist-Schicht in ihrer gesamten Dicke durchdringt. Der Maskenträger (6) ist mit einer Absorberstruktur (7) versehen, deren Struktur der Struktur entspricht, die durch mechanische Präzisionsbearbeitung der Schichten (2) und (3) erzeugt wurde. In Figur 5a sind die belichteten Bereiche (8a), die löslich geworden sind, und die unbelichteten Bereiche (9a), die unlöslich geblieben sind, dargestellt. Figur 6a zeigt die nach dem Auflösen der löslich gewordenen Bereiche (nach dem "Entwickeln") übriggebliebene Struktur im Querschnitt. In dieser Struktur mit einer leitfähigen Schicht am Boden jedes Bereiches wird Metall (10) galvanisch abgeschieden; die ausgefüllte Struktur wird mit demselben Metall in einer hinreichend dicken Schicht überdeckt, Figur 7a. Nach dem Abtragen der Grundplatte (1) sowie dem Auflösen der noch vorhandenen Teile der elektrisch nicht leitfähigen Schicht (2), der leitfähigen Schicht (3) und der unbelichteten Teile (9a) der Resist-Schicht entsteht der zweistufige Formeinsatz (10) aus Metall, Figur 8a.

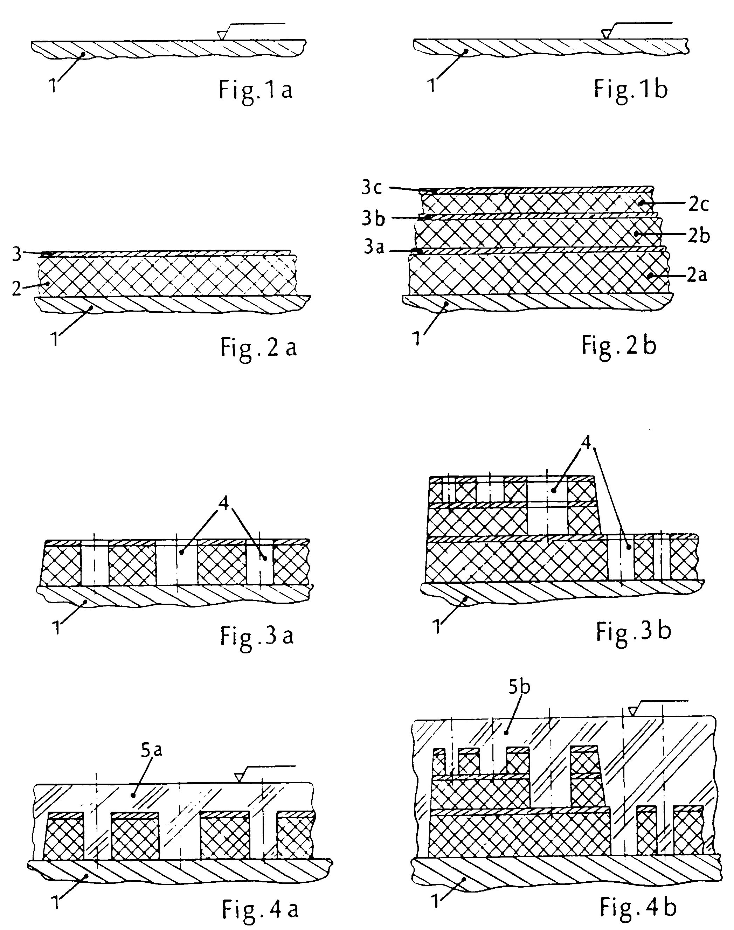

Die Figuren 1b bis 8b zeigen die Herstellung eines vierstufigen Formeinsatzes unter Verwendung eines Negativ-Resists. Auf die Grundplatte (1) mit planer oder plan bearbeiteter Oberfläche wird zunächst eine elektrisch nicht leitfähige Schicht (2a) aufgebracht, die mit einer leitfähigen Schicht (3a) abgedeckt wird. Die entsprechenden Schichten (2b), (3b), (2c) und (3c) werden anschließend aufgebracht, wodurch der Schichtenstapel entsteht. Diese sechsschichtige Platte wird in den Bereichen (4) durch mechanische Präzisionsbearbeitung abgetragen und vorstrukturiert; der Boden jedes abgetragenen Bereiches wird durch eine leitfähige Schicht oder die leitfähige Grundplatte gebildet. Die abgetragenen Bereiche können eine, mehrere oder alle nicht leitfähigen Schichten durchdringen. Die abgetragenen Bereiche werden mit einem Negativ-Resist (5b) ausgefüllt, und weiteres Resist-Material wird aufgetragen. Die Oberfläche der zusammenhängenden Resist-Schicht kann bei Bedarf mechanisch plan bearbeitet werden. Die Resist-Schicht wird durch eine Maske hindurch bestrahlt, wobei die Strahlung die Resist-Schicht in ihrer gesamten Dicke durchdringt. Der Maskenträger (6) ist mit einer Absorberstruktur (7) versehen, deren Struktur der Struktur entspricht, die durch mechanische Präzisionsbearbeitung der Schichten (2a) bis (3c) erzeugt wurde. In Figur 5b sind die belichteten Bereiche (9b), die unlöslich geworden sind, und die unbelichteten Bereiche (8b), die löslich geblieben sind, dargestellt. Figur 6b zeigt die nach dem Auflösen der löslich gebliebenen Bereiche übrigbleibende Struktur. In dieser Struktur mit einer leitfähigen Schicht am Boden jedes Bereiches wird Metall (10) galvanisch abgeschieden; die ausgefüllte Struktur wird mit demselben Metall in einer hinreichend dicken Schicht überdeckt, Figur 7b. Nach dem Abtragen der Grundplatte (1) sowie dem Auflösen der noch vorhandenen Teile der elektrisch nicht leitfähigen Schichten (2a) bis (2c), der leitfähigen Schichten (3a) bis (3c) und der belichteten Teile (9b) der Resist-Schicht entsteht der vierstufige Formeinsatz (10) aus Metall, Figur 8b.

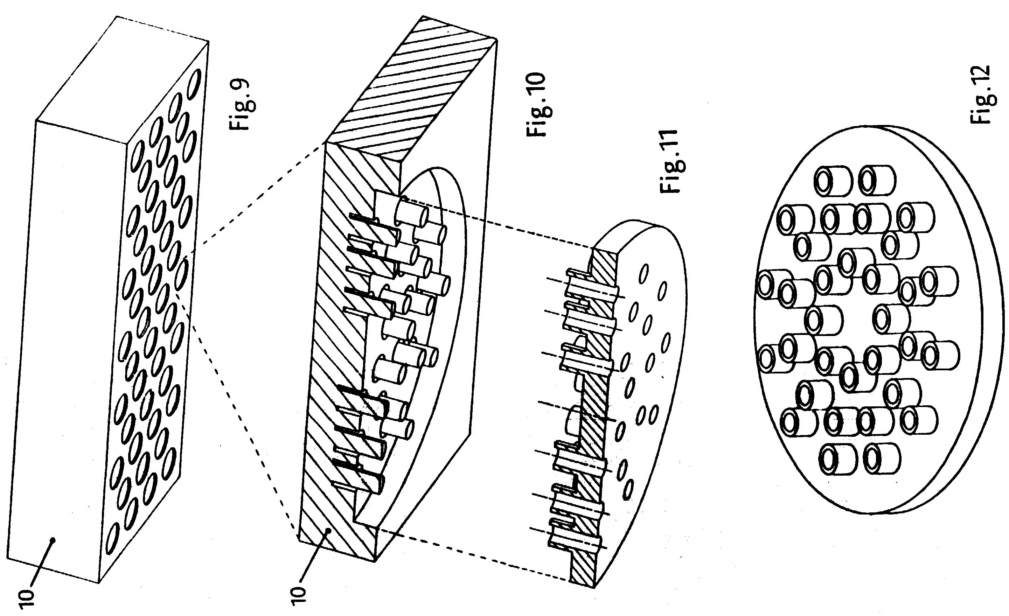

Die Figuren 9 und 10 zeigen als Beispiel die praktische Ausführung eines zweistufigen Formeinsatzes. In Figur 9 ist der durch galvanisches Abscheiden von Metall erzeugte Formeinsatz dargestellt. Die Metallplatte ist z. B. 10 mm dick, etwa 70 mm lang und etwa 30 mm breit. Sie ist vorgesehen zum gleichzeitigen Abformen von 46 Mikrostrukturkörpern. Einzelheiten eines Teilfeldes des Formeinsatzes sind in Figur 10 vergrößert und im Querschnitt dargestellt. Das Schnittbild in Figur 10 entspricht der Figur 8a.

In Figur 11 ist einer der z. B. 46 gleichzeitig aus dem Formeinsatz nach Figur 9 abgeformten Mikrostrukturkörper in Schrägansicht und im Querschnitt dargestellt. Figur 12 zeigt den zweistufigen Mikrostrukturkörper in Schrägansicht. Die wesentlichen Abmessungen dieses Mikrostrukturkörpers sind beispielsweise:
Durchmesser der Platte: 4 mm
Höhe des Körpers und Länge der Kanäle: 0,5 mm
Anzahl der Kanäle: 32 Stück
Durchmesser eines Kanals: 0,2 mm
Dicke der Kanalwand im hervorstehenden Teil: 0,05 mm

Der Mikrostrukturkörper nach Figur 12 kann als Mikroventil verwendet werden. Bei kleinem Durchsatz ist es notwendig oder zweckmäßig, die Abmessungen des Ventils entsprechend klein zu halten. Der Hub zum Betätigen eines Mikroventils ist entsprechend kurz; er bestimmt die Größe des Hubantriebes und die Schaltzeit des Mikroventils. Eine derartige Mikroventil-Platte ist ein Vielsitz-Ventil, das aus vielen parallel geschalteten Einsitz-Ventilen besteht, die über einen einzigen Ventilteller gleichzeitig öffnen oder schließen. Die Ventilsitze sind platzsparend angeordnet. Bei der zweistufigen Platte liegen die Ventilsitze erhöht; dadurch wird der Druckverlust des aus den innen angeordneten Ventilen ausströmenden Mediums erheblich vermindert. Die Strömungsverhältnisse in der Umgebung des Ventils können durch die Abstände der Ventilsitze optimiert werden. Viele einzelne Ventilsitze mit kleiner Sitzfläche ergeben eine bessere Dichtigkeit des Ventils, weil bei gegebener Schließkraft der mechanische Druck an den Sitzen groß ist.

## Patentansprüche

1. Verfahren zum Herstellen gestufter Formeinsätze, die zum Abformen gestufter Mikrostrukturkörper dienen, mit den Schritten
- Aufbringen einer elektrisch nicht leitfähigen Schicht (2) auf eine Grundplatte (1) aus elektrisch leitfähigem Material, wobei die Dicke der nicht leitfähigen Schicht im wesentlichen einer Stufenhöhe entspricht,
- Aufbringen einer elektrisch leitfähigen Schicht (3) auf die nicht leitfähige Schicht, wobei die Dicke der leitfähigen Schicht gering im Vergleich zur Dicke der nicht leitfähigen Schicht ist,
- Vorstrukturieren der auf die Grundplatte aufgebrachten Schichten durch mechanische Präzisionsbearbeitung, wobei die abgetragenen Bereich (4) bis zu der leitfähigen Grundplatte reichen,
- Ausfüllen der abgetragenen Bereiche und Überdecken der Platte mit einem Resist-Material 5a, 5b in einer Dicke, die der Gesamthöhe des später abgeformten Mikrostrukturkörpers entspricht,
- Bestrahlen der Resist-Schicht durch strukturierte Masken - bevorzugt durch eine strukturierte Maske - hindurch,
- Auflösen der löslich gewordenen oder löslich gebliebenen Bereiche des Resist-Materials und Freilegen der elektrisch leitfähigen Schicht und/oder der Grundplatte,
- galvanisches Abscheiden von Metall (10) in den Bereichen, aus denen das Resist-Material herausgelöst wurde und Überdecken aller Bereiche mit Metall in einer bis zu mehreren Millimetern dicken Schicht,
- Abtragen der Grundplatte (1) und Auflösen der restlichen Teile der leitfähigen und der nicht leitfähigen Schicht, wobei ein gestufter Formeinsatz erhalten wird.

2. Verfahren nach Anspruch 1, gekennzeichnet durch
- mehrfaches Aufbringen einer elektrisch nicht leitfähigen Schicht (2a, 2b, 2c) im Wechsel mit dem Aufbringen jeweils einer dünnen elektrisch leitfähigen Schicht 3a, 3b, 3c,
wobei die Dicke jeder nicht leitfähigen Schicht allein oder zusammen mit einer oder mehreren darüber liegenden nicht leitfähigen Schichten der Höhe einer Stufe entspricht,
- Vorstrukturieren der aufgebrachten Schichten durch mechanische Präzisionsbearbeitung, wobei jeder abgetragene Bereich auf einer leitfähigen Schicht endet und gegebenenfalls durch mehrere nicht leitfähige und leitfähige Schichten hindurchgeht.

3. Verfahren nach den Ansprüchen 1 und 2, gekennzeichnet durch
- Ausfüllen der abgetragenen Bereiche und Überdecken der Platte mit einem Positiv-Resist (5a) oder Negativ-Resist (5b) in einer Dicke, die der Gesamtdicke des später abgeformten Mikrostrukturkörpers entspricht,
- Bestrahlen der Resist-Schicht durch strukturierte Masken - bevorzugt durch eine strukturierte Maske - hindurch, wobei die mechanisch bearbeiteten Wände der aufgebrachten Schichten bevorzugt in den durch die Maske abgeschatteten oder nicht abgeschatteten Bereichen liegen.

4. Verfahren nach den Ansprüchen 1 bis 3, wobei
- die durch mechanische Präzisionsbearbeitung erzeugten Seitenwände nur zum Teil innerhalb der von der strukturierten Maske abgeschatteten oder nicht abgeschatteten Bereiche des Positiv- oder Negativ-Resists liegen.

## Claims

1. A process for preparing stepped mould inserts, which are used to mould stepped microstructure elements, with the steps
- applying an electrically non-conductive layer (2) to a base plate (1) made of electrically conductive material, the thickness of the non-conductive layer essentially corresponding to the height of a step,
- applying an electrically conductive layer (3) to the non-conductive layer, the thickness of the conductive layer being small compared to the thickness of the non-conductive layer,
- prestructuring the layers applied to the base plate by precision machining, the abraded regions (4) reaching as far as the conductive base plate,
- filling the abraded regions and covering the plate with a resist material (5a, 5b) to a thickness which corresponds to the total height of the subsequently moulded microstructure element,
- irradiating the resist layer through structured masks - preferably through one structured mask-,
- dissolving the regions of the resist material which have become soluble or have remained soluble and exposing the electrically conductive layer and/or the base plate,
- electrodepositing metal (10) in the regions from which the resist material has been dissolved and covering all the regions with metal in a layer which is up to several millimetres thick,
- abrading the base plate (1) and dissolving the remaining parts of the conductive and the non-conductive layers, a stepped mould insert being obtained.

2. A process as claimed in claim 1, characterized by
- multiple application of an electrically non-conductive layer (2a,2b,2c), alternating with the application of in each case one thin electrically conductive layer (3a,3b,3c), the thickness of each non-conductive layer, on its own or together with one or more non-conductive layers situated above it, corresponding to the height of a step,
- prestructuring of the layers applied by precision machining, each abraded region ending at a conductive layer and, if desired, passing through a plurality of non-conductive and conductive layers.

3. A process according to either of claims 1 and 2, characterized by
- filling of the abraded regions and covering of the plate with a positive resist (5a) or a negative resist (5b) to a thickness which corresponds to the total thickness of the subsequently moulded microstructure element,
- irradiation of the resist layer through structured masks - preferably through one structured mask -, the machined walls of the applied layers preferably lying in the regions which are shaded by the mask or which are not shaded.

4. A process according to any one of claims 1 to 3, in which
- the side walls produced by precision machining lie only partly within the regions of the positive or negative resist which are shaded by the structured mask or which are not shaded.

## Revendications

1. Procédé de fabrication de garnitures de moulage, qui servent à mouler des corps à microstructures étagées, comprenant les séquences suivantes:
- pose d'une couche électriquement non conductrice (2) sur une plaque de base (1), réalisée en une matière électriquement conductrice, l'épaisseur de la couche non conductrice correspondant sensiblement à la hauteur d'un étage,
- pose d'une couche électriquement conductrice (3) sur la couche non conductrice, l'épaisseur de la couche conductrice étant plus faible que celle de la couche non conductrice,
- pré-structuration des couches posées sur la plaque de base par un usinage mécanique de précision, les zones d'enlèvement (4) allant jusqu'à la plaque de base conductrice,
- remplissage des zones d'enlèvement et recouvrement de la plaque avec une matière constituée par du résiste (5a, 5b), qui correspond à la hauteur totale du corps à microstructures moulé ultérieurement,
- irradiation de la couche de résiste à travers des masques structurés - de préférence à travers un seul masque structuré,
- dissolution des zones devenues solubles ou des zones restées solubles de la matière constituée par du résiste et libération de la couche électriquement conductrice et/ou de la plaque de base,
- dépôt galvanique de métal (10) dans les zones, à partir desquelles a été éliminé le résiste et recouvrement de toutes les zones par du métal en une couche d'une épaisseur allant jusqu'à plusieurs millimètres,
- enlèvement de la plaque de base (1) et dissolution des parties restantes de la couche conductrice et de la couche non conductrice, une garniture de moulage à un étage étant obtenue.

2. Procédé selon la revendication 1,
caractérisé par
- la pose multiple d'une couche électriquement non conductrice (2a, 2b, 2c) en alternance avec la pose d'une couche mince électriquement conductrice (3a, 3b, 3c), l'épaisseur de chaque couche non conductrice prise seule ou en même temps qu'une autre couche ou plusieurs autres couches non conductrices, se trouvant dessus, correspondant à la hauteur d'un étage.
- la pré-structuration des couches mises par un usinage mécanique de précision, chaque zone d'enlèvement se terminant sur une couche conductrice et le cas échéant passant à travers plusieurs couches non conductrices et conductrices.

3. Procédé selon l'une des revendications 1 et 2,
caractérisé par
- le remplissage des zones d'enlèvement et le recouvrement de la plaque par un résiste positif (5a) ou d'un résiste négatif (5b) dans une épaisseur, qui correspond à l'épaisseur totale du corps à microstructures à mouler ultérieurement
- l'irradiation de la couche de résiste à travers des masques structurés - de préférence à travers un unique masque structuré - les parois usinées mécaniquement des couches posées se trouvant de préférence dans les zones ombragées ou non ombragées par le masque.

4. Procédé selon les revendications 1 à 3,
caractérisé en ce que
les parois latérales produites par un usinage mécanique de précision ne se trouvent qu'en partie à l'intérieur des zones ombragées ou non ombragées par le masque structuré de la couche de résiste positif ou négatif.
